Europäisches Patentamt

European Patent Office

Office européen des brevets

(19)

(11) **EP 1 679 183 A1**

(12) **EUROPEAN PATENT APPLICATION**
published in accordance with Art. 158(3) EPC

(43) Date of publication:
**12.07.2006 Bulletin 2006/28**

(51) Int Cl.:
**B32B 15/08** (1968.09)

(21) Application number: **04792581.3**

(86) International application number:
**PCT/JP2004/015412**

(22) Date of filing: **19.10.2004**

(87) International publication number:
**WO 2005/039872 (06.05.2005 Gazette 2005/18)**

(84) Designated Contracting States:
**DE FR GB**

(30) Priority: **27.10.2003 JP 2003366024**

(71) Applicant: **MITSUBISHI PLASTICS INC.**
**Chiyoda-ku,**
**Tokyo 100-0005 (JP)**

(72) Inventor: **WATANABE, Takayuki,**
**c/o MITSUBISHI PLASTICS, INC.**
**Nagahama-shi, Shiga 5268660 (JP)**

(74) Representative: **Albrecht, Thomas**
**Kraus & Weisert**
**Patent- und Rechtsanwälte**
**Thomas-Wimmer-Ring 15**
**80539 München (DE)**

(54) **REFLECTIVE FILM**

(57) [Object] To provide a reflective film whose reflectance drop by ultraviolet irradiation is slight and having excellent prevention of yellowing.

[Means for solving] The reflective film includes a base layer made of a resin composition including an aliphatic polyester resin as a main component, a metal thin film layer, and a protective layer in this order. The base layer is arranged on the side of a surface used for reflection, has voids therein with a ratio of the voids in the base layer being 50% or less, and has an average reflectance of 90% or more in a wavelength region of 420 nm to 700 nm when irradiated with light from the side of the base layer. The reflective film may have an intermediate layer between the base layer and the metal thin film layer. Also, the reflective film may have an anchor coat layer between the base layer and the metal thin film layer. The metal thin film layer may be a film vapor-deposited with silver alone or an alloy of silver and other metals or a laminate having at least one layer selected from the group consisting of a silver vapor-deposited film and the vapor-deposited film of the above-mentioned alloy. [Representative Figure] None.

**Description**

CROSS REFERENCE TO RELATED APPLICATION

This application is the U.S. national stage of International Application No.PCT/JP2004/15412, filed October 19, 2004, which was published under PCT Article 21(2) as Publication No.WO2005/039872 and of which the instant application claims the benefit, which in turn claims the benefit of Japan Patent Application No.2003-366024, filed October 27,2003. All these applications are incorporated herein by reference in their entirely.

TECHNICAL FIELD

The present invention relates to a reflective film. More particularly, the present invention relates to a reflective film for use in a reflective plate of a liquid crystal display or the like.

BACKGROUND ART

Recently, reflective films are used in the fields of a reflective plate in a liquid crystal display, a member for a projection screen or a planar light source, a reflective plate for illumination and so on. For example, in reflective plates of liquid crystal displays, a larger screen of a liquid crystal device and higher displaying performance require reflective films with high reflectivity to improve the performance of the backlight unit by supplying as much light as possible to liquid crystals.

Examples of known reflective film include those reflective films obtained by vapor depositing a thin film of a metal such as silver on a film of polyethylene terephthalate (hereinafter, sometimes referred to as "PET" for short) containing white pigment (cf., e.g., Patent Document 1: Japanese Patent Application Laid-open No.H10-193494). This reflective film has a problem that ultraviolet rays generated from the light source of a liquid crystal displaying device or the like deteriorate the film to yellow, decreasing reflectance of the reflective film. On the other hand, other known films are a film obtained by vapor depositing a thin film of a metal such as silver on a film that has kneaded therein an ultraviolet absorbent and a film that is provided with a ultraviolet-ray stable resin layer in order to increase the light resistance of the film (cf. e.g., Patent Document 2: Japanese Patent Application Laid-open No.2002-122717). However, the films have problems that they have low reflecting performance and the low reflecting performance makes brightness of the liquid crystal screen insufficient and that their light resistance is still unsatisfactory.

DISCLOSURE OF THE INVENTION

Problems to be Solved by the Invention

The present invention has been achieved with a view to solving the above-mentioned problems and it is an object of the present invention to provide a reflective film whose reflectance drop by ultraviolet rays irradiation is slight and having an excellent prevention of yellowing.

Means for Solving the Problems

The reflective film of the present invention includes a base layer made of a resin composition consisting mainly of an aliphatic polyester based resin, a metal thin film layer, and a protective layer in this order, wherein the base layer is arranged on the side of a surface used for reflection, and has voids therein with a ratio of the voids in the base layer being 50% or less, and wherein the film has an average reflectance in a wavelength region of 420 nm to 700 nm of 90% or more when irradiated with light from the side of the base layer.

Here, the reflective film may have an intermediate layer between the base layer and the metal thin film layer.

Also, the reflective film may further have an anchor coat layer between the base layer and the metal thin film layer.

The metal thin film layer may be a film vapor-deposited with silver alone or an alloy of silver and other metal(s). Alternatively, the metal thin film layer may be a laminate having at least one layer selected from the group consisting of a silver vapor-deposited film and the vapor-deposited film of the above-mentioned alloy.

The aliphatic polyester based resin may be a polylactic acid based resin.

The resin composition constituting the base layer may further contain fine powder filler.

Here, the blending amount of the fine powder filler is preferably such that aliphatic polyester based resin/fine powder filler=90/10 to 40/60 by mass ratio.

The resin composition may further contain a hydrolysis preventing agent.

Here, the blending amount of the hydrolysis preventing agent is preferably 0.1 to 3.0 mass parts per 100 mass parts of the aliphatic polyester based resin.

The base layer may be a film obtained by drawing a film made of the above-mentioned resin composition at least monoaxially to an area ratio of 5 times or more.

The liquid crystal displaying device of the present invention includes any one of the above-mentioned reflective films.

EFFECTS OF THE INVENTION

The present invention can provide reflective films whose reflectance drop by ultraviolet rays irradiation is slight and having an excellent prevention of yellowing. Also, the present invention can provide reflective films suitable for use as backlight reflective member for small liquid crystal panels such as those in notebook type computers.

MODE FOR CARRYING OUT THE INVENTION

Hereinafter, the present Invention will be explained in more detail.

The reflective film of the present invention has a base layer made of a resin composition consisting mainly of an aliphatic polyester based resin, a metal thin film layer provided on a side opposite to a side of a surface used for reflection, and a protective layer in this order.

According to the definition in Japanese Industrial Standards (JIS), "sheet" refers to a thin, flat product generally having a relatively small thickness compared with length and width, while "film" refers to a thin and flat product having an extremely smaller thickness compared with its length and width and its maximum thickness is defined. The film is usually supplied in the form of a roll (Japan Industrial Standards IIS K-6900). Accordingly, among sheets those having particularly small thicknesses may be termed as films. However, there is no clear-cut boundary between "sheet" and "film". In the present application, "films" should be understood as also including "sheets" vice versa.

The base layer is formed from a resin composition that contains an aliphatic polyester based resin as a main component. The aliphatic polyester based resin used in the present invention may include polyester based resins that contain no aromatic rings in the molecular chain, which are for example, those chemically synthesized, those obtained by fermentation by microorganisms and mixtures of these. Examples of the chemically synthesized aliphatic polyester include poly(E-caprolactam) obtained by ring-opening polymerization of lactone; polyethylene adipate, polyethylene azelate, polytetramethylene succinate, and cyclohexanedicarboxylic acid/cyclohexanedimethanol condensation products, etc., obtained by polymerization of a dibasic acid and a diol; polylactic acids based resin obtained by polymerizing hydroxycarboxylic acid; polyglycols; and aliphatic polyesters obtained by substituting a portion, for example, 50% or less of ester bonds in the above-mentioned aliphatic polyesters has been replaced by one or more of, for example, an amido bond, an ether bond, and a urethane bond. Further, the aliphatic polyester resins synthesized by fermentation by microorganisms include polyhydroxybutyrate, copolymers of hydroxybutyrate and hydroxyvalerate. In the present invention, polylactic acid based resins are preferably used.

Herein, the term "polylactic acid based resins" means homopolymers of D-lactic acid or L-lactic acid, or copolymers of these. Specifically, the polylactic acid based resins include poly(D-lactic acid) whose structural unit is D-lactic acid, poly(L-lactic acid) whose structural unit is L-lactic acid, and further, poly(DL-lactic acid) that is copolymers of L-lactic acid and D-lactic acid, and mixtures of these.

The polylactic acid based resins can be produced by known methods, such as a condensation polymerization method and a ring-opening polymerization method. For example, according to the condensation polymerization method, D-lactic acid, L-lactic acid, or mixtures of these are directly subjected to condensation polymerization with dehydration to obtain polylactic acid based resin having a desired composition. Further, in the case of ring opening polymerization method, a polylactic acid based resin having any desired composition can be obtained from a lactide, which is a cyclic dimer of lactic acid, in the presence of a predetermined catalyst and using a modifier and so on as necessary. The lactides include L-lactide, which is a dimer of L-lactic acid; D-lactide, which is a dimer of D-lactic acid; and DL-lactide, which consists of L-lactic acid and D-lactic acid. These can be mixed as necessary and polymerized to obtain polylactic acid based resins having any desired composition and crystallinity.

In the polylactic acid based resins used in the present invention, preferable compositional ratio of D-lactic acid to L-lactic acid is 100:0 to 85:15, or 0:100 to 15:85, more preferably 99.5:0.5 to 95:5, or 0.5:99.5 to 5:95. The polylactic acid based resins having a compositional ratio of D-lactic acid to L-lactic acid of 100:0 or 0:100 tend to have very high crystallinity, high melting point, excellent heat resistance, and excellent mechanical properties. Thatis, such polylactic acid based resins are preferable since upon their drawing or heat treatment, the resins crystallize to improve the heat resistance and mechanical properties. On the other hand, the polylactic acid based resins made of D-lactic acid and L-lactic acid are preferable since they are imparted therewith flexibility and films obtained therefrom have improved molding stability and drawing stability. Considering the balance between the heat resistance of and the molding stability and drawing stability of the obtained film, in polylactic acid based resins, more preferable compositional ratio of D-lactic acid to L-lactic acid is 99.5:0.5 to 95:5 or 0.5:99.5 to 5:95.

In the present invention, polylactic acid based resins with different copolymerization ratios of D-lactic acid to L-lactic acid may be blended. In this case, the compositional ratios of the polylactic acid based resins may be advantageously adjusted such that an average value of the compositional ratios of a plurality of lactic acid based resins falls within the above-mentioned ranges of the compositional ratio. Blending homopolymers of D-lactic acid and L-lactic acid and copolymers thereof makes it possible to have bleed stability and development of heat resistance well balanced.

The polylactic acid based resins used in the present invention preferably have, for example, weight average molecular weights of preferably 60,000 to 400,000, more preferably 100,000 to 300,000. When the polylactic acid based resin has a weight average molecular weight of less than 50,000, the obtained film may sometimes have poor mechanical properties.

In recent years, liquid crystal displays have been used as displays for not only personal computers but also car navigation systems and car-mounted small television sets, and such liquid crystal displays are required to be resistant to high temperatures and high humidity. A reflective sheet having an aliphatic polyester such as a polylactic acid based resin as a surface layer, when stored for a long time in a high temperature-high humidity atmosphere, may undergo hydrolysis with water vapor in the air and moisture from outside to cause a decrease in mechanical properties. Particularly in high temperature-high humidity atmosphere such as a temperature of 60°C or more and a relative humidity of 60% or more, the reflective film could be decomposed within several hours to several weeks to become useless. Accordingly, a reflective sheet that does not undergo hydrolysis in above-mentioned atmosphere is demanded.

In the present invention, it is preferable to further add a hydrolysis preventing agent to the resin composition that constitutes the base layer in order to impart the reflective sheet with resistance to hydrolysis. The hydrolysis preventing agent may include carbodiimide compounds. The carbodiimide compounds that can be used preferably include those compounds having a basic structure represented by the following general formula (1):

$$-(N=C=N-R-)_n \qquad (1)$$

wherein R represents an organic bonding unit. For example, R can be an aliphatic group, an alicyclic group, or an aromatic group. n is an integer of 1 or more, which may usually be determined between 1 to 50 as appropriate. When n is 2 or more, organic bounding units of R may be same or different.

Specific examples of the carbodiimide compound include bis(dipropylphenyl)carbodiimide, poly(4,4'-diphenylmethanecarbodiimide), poly(p-phenylenecarbodiimide), poly(m-phenylenecarbodiimide), poly(tollylcarbodiimide), poly(diisopropylphenylenecarbodiimide), poly(methyldiisopropylphenylenecarbodiimide), and poly(triisopropylphenylenecarbodiimide), and monomers of these. These carbodiimide compounds can be used singly or as combinations of two or more of them.

It is preferable that the carbodiimide compound be added to the resin composition within the range of 0.1 to 3.0 mass parts per 100 mass parts of the aliphatic polyester based resin. When the content of the carbodiimide compound is 0.1 mass parts ormore, the obtained film has improved resistance to hydrolysis. On the other hand, when the content of the carbodiimide compound is 3.0 mass parts or less, bleeding out of the carbodiimide compound does not occur, so that appearance failure of the film or a decrease in mechanical properties due to plasticization can be prevented.

The base layer that constitutes the reflective film of the present invention is arranged on the side where light is irradiated and may have voids therein. When the base layer has voids, the ratio of voids that occupy the base layer (porosity) is preferably 5% or more, more preferably 10% or more, and particularly 20% or more. When the porosity of the base layer is 5% or more, whitening of the film proceeds sufficiently. This further contributes to an increase in reflectance of the film. Further, the porosity of the base layer must be 50% or less. When the base layer has a porosity of more than 50%, the resultant film has a decreased mechanical strength, thus causing breakage of the film during production or leading to insufficient durability such as resistance to heat when in use. Accordingly, to impart the resultant film with acceptable functions as a reflective film without deteriorating the mechanical strength and durability thereof while having voids, the porosity of the base layer is desirably 5% or more and 50% or less.

Means for forming voids in the base layer include a method adding fine powder filler to the resin composition that is used to constitute the base layer and then at least monoaxially drawing the resultant film to form voids therein. This makes the best of different behaviors of the resin and the fine powder filler upon drawing. That is, when the film is drawn at a drawing temperature suitable for the resin, the resin that constitutes the matrix is drawn, while the fine powder filler tends to remain in the original state, thus causing peeling of the resin and the fine powder filler at their interface to form voids. Depending on the drawing conditions, it may be difficult to impart the film with the function of a reflecting film, or it may become impossible to impart the film with sufficient heat resistance. Therefore, drawing conditions are important.

To realize a film having voids with a porosity of 5% or more therein, it is preferable to draw the obtained sheet at an area rate of 5 times or more, more preferably 7 times or more. Preferably, the drawing is performed biaxially. Although it may be in some cases difficult to realize an area rate of 5 times or more only by monoaxial drawing, biaxial drawing readily results in an area rate of 5 times or more. That is, by biaxially drawing, a film having a higher porosity can be obtained in a stable manner and as a result, the reflectance of the film can be increased.

Further, voids formed only by monoaxial drawing are those in the form of fibers extended in one direction, while biaxial drawing makes the voids to extend in both lengthwise and breadthwise to become disk-shaped. In other words, biaxial drawing allows peeling area at the interface of the aliphatic polyester resin and the fine powder filler to increase to promote the whitening of the film. As a result, a reflective film having good reflectance can be obtained.

Biaxial drawing of a film can increase the mechanical strength of the film. Hence it is preferable that the film be drawn biaxially also from the viewpoint of the mechanical strength of the film. The film required to have heat resistance preferably has no heterogeneity in the direction in which the film is shrunk, hence it is desirable not to use the monoaxial drawing alone.

The drawing temperature at which a cast sheet is drawn is preferably the glass transition temperature of the resin (Tg) or higher and a temperature of (Tg+50°C) or lower. When the drawing temperature is the glass transition temperature (Tg) or higher, the film is not broken during drawing, so that the drawing is performed in stable. When the drawing temperature is the temperature of (Tg+50°C) or lower, drawing orientation becomes higher and the porosity increases. Thus, a film having high reflectance can be obtained with ease.

The order of drawing in biaxial drawing is not particularly limited. For example, either simultaneous biaxial drawing or sequential biaxial drawing may be used. After melting film formation using a drawing installation, either drawing of the film in an MD (direction of the film taken up) by roll drawing and subsequent drawing in a TD (perpendicular to MD) by tenter drawing, or biaxial drawing by tubular drawing may be performed.

In the present invention, a surface treatment by corona discharge or the like can be performed after the film is drawn. Alternatively, to impart the reflective film with heat resistance and dimension stability, it is preferable to perform heat fixation after the drawing. The treating temperature for the heat fixation of a film is preferably from 90°C to 160°C, more preferably from 110°C to 140°C. The treating time required for the heat fixation is preferably 1 second to 5 minutes. Installation and the like for drawing are not particularly limited. However, it is preferable to perform tenter drawing, which allows heat fixation treatment after the drawing.

The fine powder fillers to be contained in the base layer include, for example, inorganic fine powders and organic fine powders.

Examples of the inorganic fine powder that can be used include calcium carbonate, magnesium carbonate, barium carbonate, magnesium sulfate, barium sulfate, calcium sulfate, zinc oxide, magnesium oxide, calcium oxide, anatase type titanium oxide, rutile type titanium oxide, alumina, aluminum hydroxide, hydroxyapatite, silica, mica, talc, kaolin, clay, glass powder, asbestos powder, zeolite, and acid clay. Examples of the organic fine powder that can be used include polymer beads and hollow polymer beads. In the present invention, at least one fine powder selected from these can be used. The inorganic fine powder and the organic fine powder can be used in combination. Taking into consideration the light reflecting properties of the obtained film, it is preferable to use a fine powder filler having a large difference in refractive index from the base resin that constitutes the film. It is preferable to use, for example, calcium carbonate, barium sulfate, zinc oxide, or titanium oxide, having a refractive index of 1.6 or more. Fine powder filler with a higher refractive index can cause a larger difference in refractive index from the resin that constitute the film, enabling the film to have light reflecting properties easily due to refraction and scattering action at the interface between the resin and the fine powder filler.

In the present invention, it is preferable to use titanium oxide as the fine powder filler. It is particularly preferable to use among titanium oxides, a high purity titanium oxide having a high purity. The high purity titanium oxide in the present invention means titanium oxide that has low light absorbing performance with respect to visible light and a low content of coloring elements such as vanadium, iron, niobium, copper, and manganese. In the present invention, titanium oxide containing vanadium of 5 ppm or less is called "high purity titanium oxide". The high purity titanium oxide preferably has reduced amounts of coloring elements such as iron, niobium, copper, and manganese from the viewpoint of making the light absorbing performance lower.

The titanium oxides that can be used in the present invention include crystalline titanium oxides such as anatase type titanium oxide and rutile type titanium oxide. To increase a difference between the refractive index of the base resin and that of the titanium oxide, the titanium oxide preferably has a refractive index of 2.7 or more. For example, crystalline rutile type titanium oxide is preferably used.

The titanium oxide having a vanadium content of 5 ppm or less includes, for example, one produced by a chlorine process. In the chlorine process, first, rutile ore that is composed mainly of titanium oxide is reacted with chlorine gas in a high temperature oven at about 1,000°C to generate titanium tetrachloride. Then, burning the titanium tetrachloride with oxygen affords high purity titanium oxide. Methods of producing titanium oxide on an industrial scale also include a sulfuric acid process. However, the titanium oxide obtained by this process contains a relatively large amount of coloring elements such as vanadium, iron, copper, manganese, and niobium, so that the titanium oxide has a higher light absorbing performance for visible light. Accordingly, it is difficult to obtain high purity titanium oxide by the sulfuric acid method.

Since use of titanium oxide as the fine powder filler can achieve high light reflecting properties even when the porosity inside the film is low, sufficiently high light reflecting properties can be achieved even with a porosity of, for example, 15% or less. This is presumably due to the high refractive index and high hiding power of titanium oxide. In addition, if the amount of the filler is decreased, the number of voids formed by drawing is also decreased. Therefore, use of titanium oxide decreases the number of voids inside the film, so that the mechanical properties of the film can be increased while maintaining the high reflecting properties thereof. Even when a large amount of the filler is used, by drawing the film in a less drawing rate to decrease the number of voids, the mechanical properties of the film can be improved as effectively as when the amount of the used filler is decreased. It is also advantageous in increasing the dimensional stability of the film to decrease the number of voids inside the film in this manner. If high reflection performance is secured in spite of a small thickness of a film, the film can be used as a reflective film for a small, thin-type liquid crystal display used in a notebook type personal computer, a portable phone and so on. Total thickness of films that are suitable for such applications is preferably 100 $\mu$m or less, more preferably 90 $\mu$m or less, and particularly preferably 80 $\mu$m or less.

To improve the dispersibility of the fine powder filler in the resin, those fine powder fillers whose surface has been treated with a fatty acid, a fatty acid ester or the like may be used.

The fine powder filler that can be used in the present invention preferably has an average particle diameter of 0.05 $\mu$m or more and 15 $\mu$m or less, more preferably 0.1 $\mu$m or more and 10 $\mu$m or less. When the average particle diameter of the fine powder filler is 0.05 $\mu$m or more, the dispersibility of the fine powder filler in the resin is not decreased, so that a uniform film can be obtained therefrom. On the other hand, when the average particle diameter of the fine powder filler is 15 $\mu$m or less, the voids formed are not coarse, so that films having a high reflectance can be obtained.

Preferably, the fine powder filler is blended in the aliphatic polyester based resin in a dispersed manner. Considering the light reflecting properties, productivity, and mechanical properties of the film, the content of the fine powder filler in the reflective film of the present invention, is 10 mass% or more and 60 mass% or less, more preferably 20 mass% or more and 50 mass% or less based on the resin composition. When the content of the fine powder filler is more than 60 mass%, no sufficient film strength can be secured and film may be torn during the drawing of the film.

The reflective film that contains fine powder filler in a base layer can be imparted with light reflecting properties by making use of inflection and scattering of light at interfaces in the base layer. For the resin that constitutes the base layer, it is preferred to use aliphatic polyesters having a relatively small refractive index rather than the aromatic polyesters having a refractive index of about 1.55 or more. Among the aliphatic polyesters, polylactic acid based resins having the smallest refractive indices are preferable. The smaller the refractive index of such a resin is, the greater the difference is in refractive index between the resin and the fine powder filler that is used in combination, providing the film with high light reflecting properties easily. Furthermore, aliphatic polyester contain no aromatic rings in the molecular chain thereof and hence do not absorb ultraviolet rays. Therefore, the reflective films made therefrom do not yellow nor exhibit a decreased reflectance even after irradiated with ultraviolet rays.

The thickness of the base layer is preferably within the range of about 30 $\mu$m to about 500 $\mu$m and preferably about 50 $\mu$m to about 500 $\mu$m. The base layer may be a single layer construction or a multilayer construction having two or more layers made of a resin composition consisting mainly of an aliphatic polyester resin containing 10 mass% or more and 60 mass% or less of a fine powder filler.

The reflecting film of the present invention has a metal thin film layer on the back of the base layer, that is, on the side thereof opposite to the side of a surface used for reflection. The metal thin film layer can be formed by vapor depositing with metal on the base layer. For example, it can be formed by a vacuum vapor deposition method, an ionized vapor deposition method, a sputtering method, an ion-plating method or the like. Metal material to be vapor-deposited is not particularly limited so long as having high reflectance. Generally, silver, aluminum and so on are preferable, and among these, silver is particularly preferable. The metal thin film layer may be a single layer or laminate metal product, or a single layer or laminate metal oxide product. Alternatively, the metal thin film layer may be a laminate of two or more layers selected from the group consisting of a single layer metal product and a single layer metal oxide product. The thickness of the metal thin film layer may vary depending on the material that forms the metal thin film layer and the method for forming the layer but is usually within the range of preferably 10 nm to 300 nm, more preferably 20 nm to 200 nm. When the thickness of the metal thin film layer is 10 nm or more, sufficient reflectance can be obtained. On the other hand, a thickness of the metal thin layer of more than 300 nm is not preferable since no further increase in reflectance of the film can be obtained and the production efficiency of the film is decreased.

In the present invention, the metal thin film layer may be formed by depositing metal vapor on the base layer or by preparing a film formed a metal thin film layer on an intermediate layer or the like in advance and laminating this film with the base layer. Lamination may be performed by simply overlapping or by overlapping and partially or entirely bonding the base layer and the prepared metal thin film layer in the film, or a base layer and a prepared intermediate layer in the film. The bonding methods that can be used include a conventional bonding method using various adhesives, conventional heat bonding method, and so on. In the present invention, it is preferable to use those bonding methods that involve no heating or those methods that involve heat bonding at a temperature of 200˚C or less since the voids in the base layer made of the resin composition consisting mainly of aliphatic polyester resin can be retained and hence a high reflectance can be retained.

Here, a synthetic resin film can be used as the intermediate layer. Examples of such a synthetic resin film include those films made of homopolymers of polyethylene terephthalate (hereinafter, also referred to as "PET" for short), poly(meth)acrylate, polycarbonate, polyamide, and polyethersulfone, or copolymers of monomers of these resins with copolymerizable monomers. In the present invention, these films can be selected appropriately and used. The thickness of the intermediate layer is preferably 5 $\mu$m or more and more preferably 10 $\mu$m or more and 100 $\mu$m or less in view of productivity and handleability.

The reflective film of the present invention may further have an anchor coat layer between the base layer and the metal thin film layer. When the reflective film has an intermediate layer, it is preferable that the anchor coat layer be provided between the intermediate layer and the metal thin film layer. The anchor coat layer preferably has excellent transparency and is provided in order to form protrusions and depressions within a predetermined range on the surface of the layer, to increase adhesion between the metal thin film layer and the base layer or the like, to prevent yellowing of the silver vapor-deposited layer, or to increase vapor deposition capability. To form the anchor coat layer, coating materials include thermoplastic resins, thermosetting resins, electron beam curing resins, ultraviolet ray curing resins and so on can be used. Specifically, resin coating materials include amino resins, aminoalkyd resins, acrylic resins, styrene resins, acrylic-styrene copolymers, polyester resins, polyvinyl chloride resins, polyvinyl acetate resins, polyvinyl butyral, urethane resins, urea resins, melamine resins, urea-melamine resins, epoxy resins, fluorocarbon resins, polycarbonates, nitrocellulose, cellulose acetate, alkyl resins, rosin-modified maleate resins, polyamide resins alone or mixtures thereof. Such coating materials can be formed by having the resin dispersed or otherwise carried in solvents such as water or other solvents. If necessary, plasticizers, stabilizers, ultraviolet absorbents and so on may be added. Those solvents usually used for coating materials or similar ones can be used as the solvent in the present invention.

The anchor coat layer is formed by applying the above-mentioned coating material, optionally diluted with a solvent or the like as necessary, to all over a surface of the base layer or intermediate layer on the side opposite to the side of the surface used for reflection by a conventional coating method such as a gravure coating method, a roll coating method, or a dip coating method, and drying (or curing in the case of curable resins) the coating layer. The thickness of the anchor coat layer is not particularly limited and is within the range of preferably 0.01 $\mu$m to 3 $\mu$m. When the thickness of the anchor coat layer is 0.01 $\mu$m or more, it can cover the surface of the base layer uniformly. On the other hand, when the thickness of the anchor coat layer is 3 $\mu$m or less, the drying speed of the anchor coat layer is not decreased, maintaining the production efficiency.

The reflecting film of the present invention has a protective layer for protecting the metal thin film layer on a back side of the metal thin film layer, that is, on the side opposite to the side of the surface used for reflection. The material forming the protective layer is not particularly limited as long as having excellent adhesion with the metal thin film layer. For example, a coating material that includes any one of a thermoplastic resin, a thermosetting resin, an electron beam-curing resin, and an ultraviolet-curing resin can be used. Specifically, resin coating materials includes an amino resin, an aminoalkyd copolymer, an acrylic resin, a styrene resin, an acrylic-styrene resin, a urea-melamine resin, an epoxy resin, a fluorine resin, a polycarbonate, a nitrocellulose, a cellulose acetate, an alkyd resin, a rosin-modified maleate resin, or a polyamide resin alone or mixtures of these can be used. Such coating materials can be formed by dispersing the above-mentioned resin in water or other solvents. Plasticizers, stabilizers and ultraviolet absorbents may be added as necessary. Those solvents usually used for coating materials or similar ones can be used as the solvent in the present invention.

The protective layer is formed by applying the above-mentioned coating material, optionally diluted with a solvent or the like as necessary, to all over a surface of the metal thin film layer by a conventional coating method such as a gravure coating method, a roll coating method, or a dip coating method, and drying (or curing in the case of curable resins) the coating layer.

The protective layer can be formed by means other than coating the coating material. The means for forming a protective layer may include, for example, affixing films to each other, vapor deposition of other material, and sputtering. When an intermediate layer with a metal thin film layer thereon is laminated on a base layer so that the base layer contact the metal thin film layer, the intermediate layer itself of a film serves as a protective layer.

The thickness of the protective layer is not particularly limited and is preferably within the range of 0.5 $\mu$m to 5 $\mu$m. When the thickness of the protective layer is 0.5 $\mu$m or more, the protective layer can cover the surface of the metal thin film layer uniformly, effectively forming a protective layer. On the other hand, increasing the thickness of the protective layer to more than 5 $\mu$m cannot improve its effect, and the drying speed of the protective layer is rather decreased, thus decreasing the production efficiency. Therefore, the thickness of the protective layer of more than 5 $\mu$m is not preferable.

When the protective layer is to be further imparted with shielding property or stored heat diverging property, it is preferable to use resin coating material for a protective layer in which a matting agent as follows is mixed and dispersed in advance: inorganic pigment, f or example , barium sulf ate, barium carbonate, calcium carbonate, gypsum, titanium oxide, silicon oxide, alumina, silica, talc, calcium silicate, or magnesium carbonate; metal powder such as aluminum powder, brass powder or copper powder. The size of particles of the matting agent is not particularly limited and, the average particle diameter of the matting agent is preferably 0.001 μm or more and equal to or less than the thickness of the protective layer. When the matting agent has an average particle diameter of 0.001 μm or more, a uniform protective layer can be formed without aggregation of the particles of the matting agent. On the other hand, when the average particle diameter of the matting agent is equal to or less than the thickness of the protective layer, a protective layer having a smooth surface without protrusions and depressions can be formed.

Exemplary constructions of the reflective film of the present invention include a layer construction of base layer/ (optionally, anchor coat layer)/metal thin film layer/protective layer, and alternatively a layer construction of base layer/ intermediate layer/(optionally, anchor coat layer)/metal thin film layer/protective layer. In these cases, the base layer is arranged on the side where light is irradiated. The reflective film of the present invention may further have other layer (s) between these layers. Also, the base layer, metal thin film layer, etc. may be respectively constituted by a plurality of unit layers.

In the present invention, antioxidants, light stabilizers, heat stabilizers, hydrolysis preventing agents, lubricants, dispersants, ultraviolet absorbents, white pigments, fluorescent brighteners, and other additives may be blended in each layer as necessary as far as the effects of the present invention are not deteriorated.

Preferably, the reflective film of the present invention has an average reflectance of 90% or more, more preferably 95% or more at a wavelength in the range of 420 nm to 700 nm when irradiated with light from the side of the base layer. When the average reflectance of the film surface is 90% or more, the film has good reflecting properties, and with the film the screen of a liquid crystal display, etc. can realize sufficient brightness. The reflective film obtained in this way has a predetermined reflectance with which the film can serve as an acceptable reflective film. The reflective film of the present invention can exhibit good reflectance in a long wavelength region, for example, of 700 nm to 800 nm.

When a biodegradable resin is used as the resin that constitutes the reflective film, the formed film can be degraded by microorganisms in a landfill without causing waste problems. For example, when aliphatic polyester resins are subjected to earth filling, the ester bonds in the resin are hydrolyzed to reduce the molecular weight of the resin to about 1,000, and the resultant is subsequently biodegraded by microorganisms in the soil. As a result, the life of landfill sites will not be shortened, and natural landscape or environment of wild animals and plants will not be damaged.

Hereinafter, the method of producing the reflective film of the present invention will be described by way of examples. However, the present invention should not be construed as being limited thereto.
First, an aliphatic polyester based resin for constituting a base layer is blended with fine powder filler, and is further blended with additives such as a hydrolysis-preventing agent and other additives as necessary to prepare a resin composition. Specifically, fine powder filler and the like are added to the resin as necessary and the resultant is mixed in a ribbon blender, a tumbler, a Henschel mixer or the like and then kneaded using a Banbury mixer, a single-screw, a twin-screw extruder or the like at a temperature equal to or higher than the melting temperature of the resin to provide a resin composition for the base layer. Alternatively, the resin composition can also be obtained by preparing in advance a master batch obtained by blending a portion of the resin with the fine powder filler in high concentrations, then, mixing the master batch with another portion of the resin to desired concentrations of the components.

Then, the thus-obtained resin composition for the base layer is melted and formed into a film. The preferably used method for forming the resin composition into a film generally includes an inflation molding method or an extrusion molding method using a T-die. Specifically, after the resin composition for the base layer is dried, it is supplied to an extruder and heated at a temperature equal to or higher than the melting point of the resin to melt the resin. Alternatively, the resin composition may be supplied directly to the extruder without drying. However, when the resin composition is not dried before it can be supplied to the extruder, it is preferable to use a vacuum vent. The conditions of extrusion such as extrusion temperature must be set taking into consideration various factors, for example, a reduction in molecular weight of the resin due to decomposition. For example, the extrusion temperature is preferably in the range of 170˚C to 280˚C. Thereafter, the molten resin composition for the base layer is extruded from a slit-shaped discharge nozzle of a T-die and contacted with a cooling roll to solidify the composition to form a cast sheet.

It is preferable that the base layer is drawn at least monoaxially, more preferably biaxially. The drawing can be performed by a roll, a tenter, air inflation, a tubular, a mandrel or the like. For example, after the film is drawn in the MD by roll drawing, it may be subsequently drawn either in a TD by tenter drawing, or biaxially by tubular drawing. Then, heat fixation may be performed as necessary to obtain a reflective film.

Then, a rein coating material for an anchor coat layer is coated on the base layer as necessary and dried (or cured). On this anchor coat layer, vapor deposition of a metal such as silver is performed. Thereafter, the resin coating material for a protective layer is coated on the metal thin film layer and dried (or cured) to form a protective layer. In this manner, a reflective film (base layer/anchor coat layer/metal thin film layer/protective layer) can be obtained.

Alternatively, an anchor coat layer is separately formed on an intermediate layer, and a metal is vapor deposited on the anchor coat layer. Then a protective layer is formed on the metal-vapor-deposited surface. The base layer and the intermediate layer thus formed can be affixed to each other to form a reflective film (base layer/intermediate layer/ anchor coat layer/metal thin film layer/protective layer).

In recent years, there has been an increasing demand for light-weight, small-sized notebook type personal computers and car-mounted miniature television set and so on and a thin-type liquid crystal panel that is compatible therewith is keenly demanded. Accordingly, a thin reflective film is also keenly demanded. The reflective film of the present invention can be formed into a thin film and can respond to such a demand. That is, the reflective film of the present invention can be realized as one having a total thickness of less than 100 $\mu$m, more particularly 80 $\mu$m or less.

EXAMPLES

Hereinafter, the present invention is explained in more detail by examples. However, the present invention should not be considered to be limited thereto. Instead, various applications or modifications may be made without departing the technical concept of the present invention. Measurements and evaluations in the examples were performed as below. Here, the direction in which the film is taken up (direction of flow of film) is indicated by MD (Machine Direction) and the direction perpendicular thereto is indicated by TD (Transverse Direction).

(Measurement and Evaluation Methods)

(1) Average Particle Diameter
By using a powder specific surface area measuring apparatus (permeation method), model "SS-100" manufactured by Shimadzu Corporation with a sample tube of 2 cm$^2$ in cross section and 1 cm in height, the time in which 20 cc of air was permeated through a 3-g sample packed in the sample tube at 500 mm H$_2$O was repeatedly measured, and an average particle diameter of the sample was calculated from the measured values.

(2) Porosity (%)
The density of a film before drawing (indicated as "non-drawn film density") and the density of the film after drawing (indicated as "drawn film density") were measured, and the measured values were assigned in the following equation to obtain the porosity of the film.

$$\textbf{Porosity (\%) = \{(Non-drawn film density - Drawn film density)/Non-drawn film density\} × 100}$$

(3) Reflectance (%)
By using a spectrophotometer ("U-4000", manufactured by Hitachi, Ltd.) with an integrating sphere, reflectance of a sample film was measured taking the reflectance of an alumina white plate as 100% at intervals of 2 nm over a wavelength range of 420 nm to 800 nm. Light was irradiated from the side of the base layer. An average value of the measured values in a wavelength region of 420 nm to 700 nm was calculated, and this value was defined as an average reflectance at a wavelength of 420 nm to 700 nm.
Also, a reflectance with light at a wavelength of 800 $\mu$m was read.

(4) Yellowing preventing property
In a UV fade-o-meter tester, a film was irradiated with ultraviolet rays for 1,000 hours. Thereafter, an average reflectance (%) of the film after irradiation of ultraviolet rays was obtained according to the above-mentioned measuring method of (3). A film that showed a difference between an average reflectance after the irradiation of ultraviolet rays and an average reflectance before the irradiation of ultraviolet rays being less than 5% was judged to have yellowing preventing property and indicated by a symbol "○". On the other hand, a film that showed such a difference in average reflectance between before and after the irradiation with ultraviolet rays of 5% or more was judged to have poor yellowing preventing property and indicated by a symbol "×".

(5) Competence for use as a reflective member for the backlight of a small-size liquid crystal panel

A film that had a thickness of less than 100 µm and an average reflectance of 95% or more was judged to have competence. A film that met this requirement was indicated by a symbol " ○" while a film that did not meet this requirement was indicated by a symbol "×".

The polylactic acid based resins used in the examples were prepared as follows.

[Preparation of Polylactic Acid Based Resin (PLA) (I): L-form content 99.5%]

100 kg of L-lactide (trade name: PURASORB L) manufactured by Purac Japan Co. , Ltd. to which 15-ppm tin octylate was added was charged in a 500-liter batch-type polymerization tank equipped with an agitator and a heater. Then, the polymerization tank was purged with nitrogen and polymerization was performed under conditions of a temperature of 185˚C and an agitation speed of 100 rpm for 60 minutes to obtain a melt. The obtained melt was supplied to a 40-mmφ equidirectional twin-screw extruder equipped with three stages of a vacuum vent, manufactured by Mitsubishi Heavy Industries, Ltd., and was extruded into strands at 200˚C while evaporating volatile components at a vent pressure of 4 Torr to obtain pellets of a polylactic acid based resin.

The obtained polylactic acid based resin had a weight average molecular weight of 200,000, an L-form content of 99.5%, and a D-form content of 0.5%. The polymer had a glass transition temperature (Tg) of 65˚C.

[Example 1]

(Preparation of Base Layer)

Pellets of polylactic acid based resin (1) having a weight average molecular weight of 200,000 (D-form content of 0.5%, glass transition temperature of 65˚C) and rutile type titanium oxide (vanadium content of 5 ppm or less: produced by a chlorine method) having an average particle diameter of 0.25 µm were mixed in a ratio of 80 mass%/20 mass% to form a mixture. 2 mass parts of a hydrolysis preventing agent, bis(dipropylphenyl)carbodiimide, was added to 100 mass parts of the mixture and mixed, followed by preparing a resin composition through a twin-screw extruder.

Then, the obtained resin composition was extruded using a single screw extruder through a T-die at 220˚C, and cooled to solidify to form a cast sheet. The obtained cast sheet was biaxially drawn at a temperature of 65˚C in a draw ratio of 3 times in the MD and 3 times in the TD. Thereafter, the drawn sheet was heat-treated at 140˚C to obtain a 60-µm-thick film for a base layer.

(Preparation of Reflective Film)

On one side of the formed film for a base layer was coated with a coating solution obtained by diluting a polyester resin coating material consisting mainly of polyester resin with a solvent. Then, the coating was dried to form an anchor coat layer having a thickness of 1 µm. On the anchor coat layer was vacuum-deposited with silver to form a metal thin film layer having a thickness of 80 µm.

Then, the entire surface of the metal thin film layer was coated with a melamine-epoxy resin coating material containing titanium oxide and diluted with a solvent, and the coating was dried to form a protective layer having a thickness of 1.5 µm. Thus, a reflective film having a thickness of about 63 µm was produced. The obtained reflective film was subjected to various evaluations as described above. The results obtained are shown in Table 1.

[Example 2]

A reflective film having a thickness of about 63 µm was prepared in the same manner as in Example 1 except that anatase type titanium oxide having an average particle diameter of 0.16 µm was used instead of rutile type titanium oxide.

The obtained film was subjected to the same measurement and evaluation as those in Example 1. The results obtained are shown in Table 1.

[Example 3]

A reflective film having a thickness of about 63 µm was prepared in the same manner as in Example 1 except that zinc oxide having an average particle diameter of 0.4 µm was used instead of rutile type titanium oxide.

The obtained film was subjected to the same measurement and evaluation as those in Example 1. The results obtained are shown in Table 1.

[Example 4]

A reflective film having a thickness of about 63 $\mu$m was prepared in the same manner as in Example 1 except that barium sulfate having an average particle diameter of 0.7 $\mu$m was used instead of rutile type titanium oxide.
The obtained film was subjected to the same measurement and evaluation as those in Example 1. The results obtained are shown in Table 1.

[Example 5]

A reflective film having a thickness of about 63 $\mu$m was prepared in the same manner as in Example 1 except that calcium carbonate having an average particle diameter of 0.15 $\mu$m was used instead of rutile type titanium oxide in Example 1.
The obtained film was subjected to the same measurement and evaluation as those in Example 1. The results obtained are shown in Table 1.

[Example 6]

(Preparation of Base Layer)

Pellets of polylactic acid based resin (I) having a weight average molecular weight of 200,000 (D-form content of 0.5%, glass transition temperature of 65˚C) and rutile type titanium oxide (vanadium content of 5 ppm or less: produced by a chlorine method) having an average particle diameter of 0.25 $\mu$m were mixed in a ratio of 80 mass%/20 mass% to form a mixture. 2 mass parts of a hydrolysis preventing agent, bis(dipropylphenyl)carbodiimide, was added to 100 mass parts of the mixture and mixed, followed by preparing a resin composition through a twin-screw extruder.
Then, the obtained resin composition was extruded using a single screw extruder through a T-die at 220˚C, and cooled to solidify to form a cast sheet. The obtained cast sheet was biaxially drawn at a temperature of 65˚C in a draw ratio of 3 times in the MD and 3 times in the TD. Thereafter, the drawn sheet was heat-treated at 140˚C to obtain a 60-$\mu$m-thick film for a base layer.

(Preparation of film having intermediate layer)

One side of a polyethylene terephthalate film having a thickness of 25 $\mu$m was coated with a coating solution obtained by diluting a polyester resin coating material with a solvent. Then, the coating was dried to form an anchor coat layer having a thickness of 1 $\mu$m. On the anchor coat layer silver was vacuum-deposited to form a metal thin film layer having a thickness of 80 nm. Subsequently, the entire surface of the metal thin film layer was coated with a melamine-epoxy resin coating material containing titanium oxide diluted with a solvent, and the coating was dried to form a protective layer having a thickness of 1.5 $\mu$m. Thus, a film having an intermediate layer (having a thickness of 28 $\mu$m) was produced.

(Preparation of reflecting film)

The formed film for a base layer and the formed film were superimposed with the intermediate layer side inside to prepare a reflective film having a thickness of about 88 $\mu$m.
The obtained reflective film was subjected to various evaluations as described above. The results obtained are shown in Table 1.

[Example 7]

A reflective film having a thickness of about 88 $\mu$m was prepared in the same manner as in Example 6 except that barium sulfate having an average particle diameter of 0.7 $\mu$m was used instead of rutile type titanium oxide.
The obtained film was subjected to the same measurement and evaluation as those in Example 6. The results obtained are shown in Table 1.

[Example 8]

A reflective film having a thickness of about 88 $\mu$m was prepared in the same manner as in Example 6 except that calcium carbonate having an average particle diameter of 0.15 $\mu$m was used instead of rutile type titanium oxide.
The obtained film was subjected to the same measurement and evaluation as those in Example 6. The results obtained are shown in Table 1.

[Example 9]

A reflective film having a thickness of about 88 μm was prepared in the same manner as in Example 6 except that the film for a base film and the film having an intermediate layer were superimposed heat-bonding edges of the film for a base layer and edges of the film having an intermediate layer to form a laminate.
The obtained film was subjected to the same measurement and evaluation as those in Example 6. The results obtained are shown in Table 1.

[Example 10]

A reflective film having a thickness of about 88 μm was prepared in the same manner as in Example 6 except that the film for a base film and the film having an intermediate layer were superimposed partially bonding edges of the film for a base layer and edges of the film having an intermediate layer with an acrylic adhesive to form a laminate.
The obtained film was subjected to the same measurement and evaluation as those in Example 6. The results obtained are shown in Table 1.

[Comparative Example 1]

A 38-μm-thick polyethylene terephthalate film having kneaded therein titanium oxide so as to adjust the total light transmittance to 14% (trade name "DIAFOIL W-400", manufactured by DIAFOIL CORPORATION) was provided as a base layer. On a side of polyethylene terephthalate film opposite to the side used for reflection was coated a coating solution obtained by diluting a polyester resin coating material with a solvent. Then, the coating was dried to form an anchor coat layer having a thickness of 1 μm.
Subsequently, silver was vacuum-deposited on the anchor coat layer to form a vaper-deposited silver layer having a thickness of 80 nm. Thereafter, the entire surface of the vapor-deposited silver layer was coated with the same coating solution of a melamine-epoxy resin coating material (containing titanium oxide) diluted with a solvent as that in Example 1, and the coating was dried to form a protective layer having a thickness of 1.5 μm. Thus, a reflective film having a thickness of 40 μm was formed. The obtained reflective film was subjected to the same evaluations as those in Example 1. The results obtained are shown in Table 1.

[Comparative Example 2]

A 25-μm-thick polyethylene terephthalate film was provided as a base layer. One side of the polyethylene terephthalate film was coated with an ultraviolet-stable resin (manufactured by NIPPON SHOKUBAI CO., LTD.; trade name "UV-G714"), which was dried to form an ultraviolet-stable resin layer having a thickness of 1 μm.
Subsequently, a side of the polyethelene terephthalete film opposite to the side of an ultraviolet-stable resin layer was coated with a coating solution obtained by diluting the same polyester resin coating material as that in Example 1 with a solvent, and the coating was dried to form an anchor coat layer having a thickness of 1 μm. The anchor coat layer was vacuum-deposited with silver to form a metal thin film layer having a thickness of 80 μm. Thereafter, the entire surface of the metal thin film layer was coated with the same melamine-epoxy resin coating material (containing titanium oxide) as that in Example 1 diluted with a solvent, and the coating was dried to form a protective layer having a thickness of 1.5 μm. Thus, a reflective film having a thickness of about 30 μm was formed. The obtained film was subjected to the same evaluations as those in Example 1. The results obtained are shown in Table 1.

[Comparative Example 3]

Pellets of polylactic acid based resin (I) having a weight average molecular weight of 200,000 (D-form content of 0.5%, glass transition temperature of 65˚C) and rutile type titanium oxide having an average particle diameter of 0.25 μm were mixed in a ratio of 80 mass%/20 mass% to form a mixture. 2 mass parts of a hydrolysis preventing agent, bis (dipropylphenyl)carbodiimide, was added to 100 mass parts of the mixture and mixed, followed by preparing a resin composition through a twin-screw extruder.
Then, the obtained resin composition was extruded using a single screw extruder through a T-die at 220˚C, and cooled to solidify to form a cast sheet. The obtained cast sheet was biaxially drawn at a temperature of 65˚C in a drawing ratio of 3 times in the MD and 3 times in the TD. Thereafter, the drawn sheet was heat-treated at 140˚C to obtain an about 150-μm-thick reflective film.
The obtained reflective film was subjected to the various evaluations as described above. The results obtained are shown in Table 1.
[Table 1]

| | Thickness (μm) | Porosity (%) | Average reflectance (%) | | Decrease in reflectance | Yellowing preventing property | Competence for use | Reflectance at 800 nm (%) |
|---|---|---|---|---|---|---|---|---|
| | | | Before irradiation | After irradiation | | | | |
| Ex.1 | About 63 | 20 | 99 | 98 | 1 | ○ | ○ | 99 |
| Ex.2 | About 63 | 25 | 99 | 98 | 1 | ○ | ○ | 99 |
| Ex.3 | About 63 | 30 | 99 | 98 | 1 | ○ | ○ | 99 |
| Ex.4 | About 63 | 30 | 99 | 98.5 | 0.5 | ○ | ○ | 99 |
| Ex.5 | About 63 | 32 | 98.5 | 98 | 0.5 | ○ | ○ | 99 |
| Ex.6 | About 88 | 20 | 99 | 98 | 1 | ○ | ○ | 99 |
| Ex.7 | About 88 | 30 | 99 | 98.5 | 0.5 | ○ | ○ | 99 |
| Ex.8 | About 88 | 32 | 98.5 | 98 | 0.5 | ○ | ○ | 99 |
| Ex.9 | About 88 | 20 | 99 | 98 | 1 | ○ | ○ | 99 |
| Ex.10 | About 88 | 20 | 99 | 98 | 1 | ○ | ○ | 99 |
| C.Ex.1 | About 40 | - | 94 | 70 | 24 | × | × | 96 |
| C.Ex.2 | About 30 | - | 94 | 88 | 6 | × | × | 96 |
| C.Ex.3 | About 150 | 20 | 99 | 97.5 | 1.5 | ○ | × | 96 |

According to Table 1, the reflective films of Examples 1 to 10 according to the present invention exhibited high reflectance over a wavelength region of 420 nm to 700 nm and an average reflectance of as high as 95% or more after irradiation with ultraviolet rays and also showed a low decrease in reflectance due to irradiation with ultraviolet rays and excellent yellowing preventing property. Further, the reflective films of Examples 1 to 10 had excellent reflectance at 800 nm, thus having good reflecting performance in a high wavelength band. Furthermore, the reflective films of Examples 1 to 10 had a total thickness of less than 100 $\mu$m, indicating that they can be applied to reflective plates of compact liquid crystal panels.

On the other hand, it revealed that the films of Comparative Examples 1 and 2 made of resin compositions consisting mainly of an aromatic polyester resin exhibited an average reflectance of less than 95% and a decrease in reflectance of 5% or more after irradiation with ultraviolet rays, indicating that they had a poor yellowing preventing property. The film of Comparative Example 3 is a monolayer film consisting mainly of a polylactic acid based resin having thickness of 100 $\mu$m or more, which could not be applied to a backlight reflecting material for a compact liquid crystal panels. Note that to realize an average reflectance of 95% or more in reflective films of such a construction, a thickness of 100 $\mu$m or more was necessary. Further, the reflective films of Comparative Examples 1 to 3 had a reflectance of 96% at a wavelength of 800 nm, showing a decrease in reflecting performance in a high wavelength band.

INDUSTRIAL APPLICABILITY

The reflective films of the present invention can be used as reflective plates in various liquid crystal displays for mobile phones and personal computers, members of planar light sources, projection screens and so on. Also, the reflective films of the present invention can be used as thin-type reflective member such as a reflective member for the backlight of a compact liquid crystal panel in a car-mounted miniature television set and so on.

**Claims**

1.    A reflective film comprising a base layer made of a resin composition including an aliphatic polyester based resin as a main component, a metal thin film layer, and a protective layer in this order, wherein the base layer is arranged on the side of a surface used for reflection, and has voids therein with a ratio of the voids in the base layer being 50% or less, and wherein the film has an average reflectance of 90% or more in a wavelength region of 420 nm to 700 nm when irradiated with light from the side of the base layer.

2.    The reflective film according to claim 1, further comprising an intermediate layer between the base layer and the metal thin film layer.

3.    The reflective film according to claim 1 or 2, further comprising an anchor coat layer between the base layer and the metal thin film layer.

4.    The reflective film according to any one of claims 1 to 3, wherein the metal thin film layer is a film vapor-deposited with silver alone or with an alloy of silver and other metal, or a laminate having at least one layer selected from the group consisting of a silver vapor-deposited film and the vapor-deposited film of the above-mentioned alloy.

5.    The reflective film according to any one of claims 1 to 4, wherein the aliphatic polyester based resin is a polylactic acid based resin.

6.    The reflective film according to any one of claims 1 to 5, wherein the resin composition constituting the base layer further contains fine powder filler.

7.    The reflective film according to any one of claims 1 to 6, wherein the resin composition further contains a hydrolysis preventing agent.

8.    The reflective film according to claim 6 or 7, wherein the blending amount of aliphatic polyester based resin/fine powder filler is 90/10 to 40/60 by mass ratio.

9.    The reflective film according to claim 7 or 8, wherein the blending amount of the hydrolysis preventing agent is 0.1 to 3.0 mass parts per 100 mass parts of the aliphatic polyester based resin.

10.  The reflective film according to any one of claims 1 to 9, wherein the base layer is a film obtained by drawing a film made of the resin composition at least monoaxially to an area ratio of 5 times or more.

**11.** A reflective plate for a liquid crystal display device, wherein the reflective plate for a liquid crystal display device comprises the reflective film according to any one of claims 1 to 10.

**INTERNATIONAL SEARCH REPORT**

| International application No. |
|---|
| PCT/JP2004/015412 |

A. CLASSIFICATION OF SUBJECT MATTER
Int.Cl$^7$  B32B15/08

According to International Patent Classification (IPC) or to both national classification and IPC

B. FIELDS SEARCHED

Minimum documentation searched (classification system followed by classification symbols)
Int.Cl$^7$  B32B1/00-35/00

Documentation searched other than minimum documentation to the extent that such documents are included in the fields searched
Jitsuyo Shinan Koho          1926-1996    Toroku Jitsuyo Shinan Koho    1994-2004
Kokai Jitsuyo Shinan Koho    1971-2004    Jitsuyo Shinan Toroku Koho    1996-2004

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| Y | JP 10-193494 A (Onoike Kogyo Kabushiki Kaisha), 28 July, 1998 (28.07.98), (Family: none) | 1-11 |
| Y | JP 10-36650 A (Mitsui Toatsu Chemicals, Inc.), 10 February, 1998 (10.02.98), Par No. [0004] (Family: none) | 1-11 |
| Y | JP 2001-303465 A (Kyowa Kabushiki Kaisha, Unitika Fiber Kabushiki Kaisha), 31 October, 2001 (31.10.01), Par No. [0005] (Family: none) | 1-11 |

☒  Further documents are listed in the continuation of Box C.          ☐  See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 18 January, 2005 (18.01.05) | 08 February, 2005 (08.02.05) |

| Name and mailing address of the ISA/ | Authorized officer |
|---|---|
| Japanese Patent Office | |
| Facsimile No. | Telephone No. |

Form PCT/ISA/210 (second sheet) (January 2004)

**EP 1 679 183 A1**

<table>
<tr><td colspan="2" align="center">**INTERNATIONAL SEARCH REPORT**</td><td>International application No.<br>PCT/JP2004/015412</td></tr>
</table>

C (Continuation). DOCUMENTS CONSIDERED TO BE RELEVANT

| Category* | Citation of document, with indication, where appropriate, of the relevant passages | Relevant to claim No. |
|---|---|---|
| Y | JP 2000-234251 A (Toray Industries, Inc.),<br>29 August, 2000 (29.08.00),<br>(Family: none) | 1-11 |
| Y | JP 2002-88630 A (Unitika Ltd.),<br>27 March, 2002 (27.03.02),<br>(Family: none) | 1-11 |
| Y | JP 11-80522 A (Nisshinbo Industries, Inc.),<br>26 March, 1999 (26.03.99),<br>& EP 890604 A          & US 5973024 A<br>& US 6107378 A | 7,9 |
| Y | JP 2002-122717 A (Onoike Kogyo Kabushiki Kaisha),<br>26 April, 2002 (26.04.02),<br>(Family: none) | 1-11 |
| A | JP 10-249945 A (Asahi Chemical Industry Co., Ltd.),<br>22 September, 1998 (22.09.98),<br>Par Nos. [0001], [0025]<br>(Family: none) | 1-11 |
| A | JP 2000-85054 A (Daicel Chemical Industries, Ltd., Unic Corp.),<br>28 March, 2000 (28.03.00),<br>& EP 987100 A          & US 2002/150775 A | 1-11 |

Form PCT/ISA/210 (continuation of second sheet) (January 2004)

**EP 1 679 183 A1**

**INTERNATIONAL SEARCH REPORT**

International application No.

PCT/JP2004/015412

C (Continuation). DOCUMENTS CONSIDERED TO BE RELEVANT

| Category* | Citation of document, with indication, where appropriate, of the relevant passages | Relevant to claim No. |
|---|---|---|
| Y | JP 2000-234251 A (Toray Industries, Inc.),<br>29 August, 2000 (29.08.00),<br>(Family: none) | 1-11 |
| Y | JP 2002-88630 A (Unitika Ltd.),<br>27 March, 2002 (27.03.02),<br>(Family: none) | 1-11 |
| Y | JP 11-80522 A (Nisshinbo Industries, Inc.),<br>26 March, 1999 (26.03.99),<br>& EP 890604 A          & US 5973024 A<br>& US 6107378 A | 7,9 |
| Y | JP 2002-122717 A (Onoike Kogyo Kabushiki Kaisha),<br>26 April, 2002 (26.04.02),<br>(Family: none) | 1-11 |
| A | JP 10-249945 A (Asahi Chemical Industry Co., Ltd.),<br>22 September, 1998 (22.09.98),<br>Par Nos. [0001], [0025]<br>(Family: none) | 1-11 |
| A | JP 2000-85054 A (Daicel Chemical Industries, Ltd., Unic Corp.),<br>28 March, 2000 (28.03.00),<br>& EP 987100 A          & US 2002/150775 A | 1-11 |

Form PCT/ISA/210 (continuation of second sheet) (January 2004)

17